# FASCICULE DE BREVET EUROPEEN

(11) **EP 3 974 765 B1**
(45) Date de publication et mention de la délivrance du brevet: **07.06.2023**
(21) Numéro de dépôt: 21195436.7
(22) Date de dépôt: 08.09.2021
(51) Int. Cl.: F42C 19/02, F42C 19/06, F42C 11/00, H05K 3/28

(54) **FUSÉE ÉLECTRONIQUE POUR PROJECTILE**
ELEKTRONISCHER PROJEKTILZÜNDER
ELECTRONIC WARHEAD FOR PROJECTILE

(30) Priorité: 25.09.2020 FR 2009700
(43) Date de publication de la demande: 30.03.2022
(73) Titulaire: Nexter Munitions, 78000 Versailles (FR)
(72) Inventeur: PAVIER, Julien, 18023 BOURGES (FR)
(74) Mandataire: Cabinet Chaillot

(56) Documents cités:
- DE-A1- 2 347 049
- FR-A1- 2 666 190
- FR-A1- 2 713 396
- US-A- 3 652 333
- US-A1- 2005 115 440

## Description

Le domaine technique de l'invention est celui des fusées électroniques pour projectiles. US 2005/115440 A1 montre une fusée électronique pour projectile.

Les fusées de projectiles sont des dispositifs assurant le déclenchement du projectile en réponse à certains évènements : impact sur une cible, temps écoulé après le tir, proximité d'une cible donnée...

Si les fusées sensibles au seul impact sont les plus simples et sont totalement mécaniques, les fusées qui détectent un temps ou une proximité de cible, voire un retard après impact ou encore qui ont plusieurs modes de fonctionnement possibles (programmables par un utilisateur), incorporent une ou plusieurs cartes électroniques.

Il se pose alors le problème d'assurer la protection de ces cartes électroniques contre les chocs et les vibrations.

En effet, les cartes électroniques doivent pouvoir résister aux contraintes de tir du projectile : accélérations de l'ordre de 981000 m/s² pour des projectiles de moyen calibre (calibre inférieur à 50 mm) accélérations de l'ordre de 150000 m/s² pour des projectiles de gros calibre (calibre supérieur à 50 mm) .

Elles doivent également résister aux vibrations intervenant lors des phases de transport logistique et de déplacement du projectile dans les dispositifs de chargement.

Elles doivent enfin résister aux chocs pouvant intervenir sur trajectoire : sortie de bouche, traversée d'obstacles légers tels que branchages ou surprotections des cibles.

Une solution classique pour assurer la protection des cartes électroniques est de les enrober dans un couche de résine assurant à la carte électronique une certaine rigidité empêchant sa flexion.

La carte enrobée est ensuite noyée dans un bloc amortisseur, par exemple en élastomère, pour amortir les vibrations.

Ces moyens d'enrobage sont par exemple décrits par les brevets : FR2713396 et FR2666190.

Les moyens d'enrobage connus présentent cependant des inconvénients.

Ils nécessitent le plus souvent une encapsulation totale des cartes dans le corps de projectile ce qui complique le procédé de fabrication et de montage du projectile et interdit tout démontage ultérieur.

Par ailleurs les moyens connus sont insuffisants pour protéger les cartes électroniques contre les chocs intervenant sur trajectoire, tels que les impacts sur des plaques de surprotection.

C'est le but de l'invention que de proposer une fusée électronique permettant de faciliter son intégration dans un projectile sans pour autant diminuer la protection de la ou des cartes électroniques qui la composent.

C'est un autre but de proposer une fusée électronique dont les caractéristiques de résistance aux chocs et aux vibrations peuvent être facilement adaptées en fonction des besoins opérationnels particuliers.

Ainsi l'invention a pour objet une fusée électronique pour projectile comprenant au moins une carte électronique disposée dans un logement du corps du projectile, carte qui est enrobée par un bloc de matériau de protection, fusée caractérisée en ce que la carte est solidaire d'au moins une tige support partiellement enrobée par le bloc de protection, tige support qui est engagée au travers d'un trou d'une paroi solidaire du corps de projectile, la tige étant rendue solidaire de la paroi par un moyen de fixation, un premier moyen de découplage étant interposé entre le bloc et la paroi et un second moyen de découplage étant interposé entre le moyen de fixation et la paroi, la carte se trouvant disposée vers une partie avant du projectile et la paroi vers une partie arrière du projectile.

Selon un mode particulier de réalisation, le premier et/ou le second moyen de découplage pourront comprendre au moins un moyen déformable élastiquement.

Avantageusement le moyen déformable élastiquement pourra être constitué par un ressort et/ou au moins une rondelle déformable et/ou au moins un tube d'élastomère.

Selon un autre mode de réalisation, le second moyen de découplage pourra comprendre au moins un dispositif d'absorption d'énergie.

Selon un mode particulier de réalisation, le dispositif d'absorption d'énergie pourra comprendre un tube d'élastomère inséré dans une gaine métallique, le moyen de fixation étant en appui contre le tube d'élastomère de façon à pouvoir écraser celui-ci par inertie lors d'un choc du projectile sur une cible.

Selon un mode particulier de réalisation, le dispositif d'absorption d'énergie pourra comprendre un tube d'élastomère inséré dans une couche de mousse d'aluminium ou de polymère, le moyen de fixation ayant une tête élargie pouvant écraser le tube et la couche de mousse par inertie lors d'un choc du projectile sur une cible.

Selon une variante, le bloc de matériau de protection pourra être disposé dans un boîtier dont une paroi de fond sera traversée par la ou les tiges supports.

L'invention sera mieux comprise à la lecture de la description qui va suivre de différents modes de réalisation, description faite en référence aux dessins annexés et dans lesquels :
[Fig. 1] montre de façon schématique et en coupe longitudinale une fusée selon un premier mode de réalisation ;
[Fig. 2] montre de façon schématique et en coupe longitudinale une fusée selon un deuxième mode de réalisation ;
[Fig. 3] montre de façon schématique et en coupe longitudinale une fusée selon un troisième mode de réalisation ;
[Fig. 4] montre de façon partielle et en coupe longitudinale une variante de réalisation d'une fusée selon l'invention.

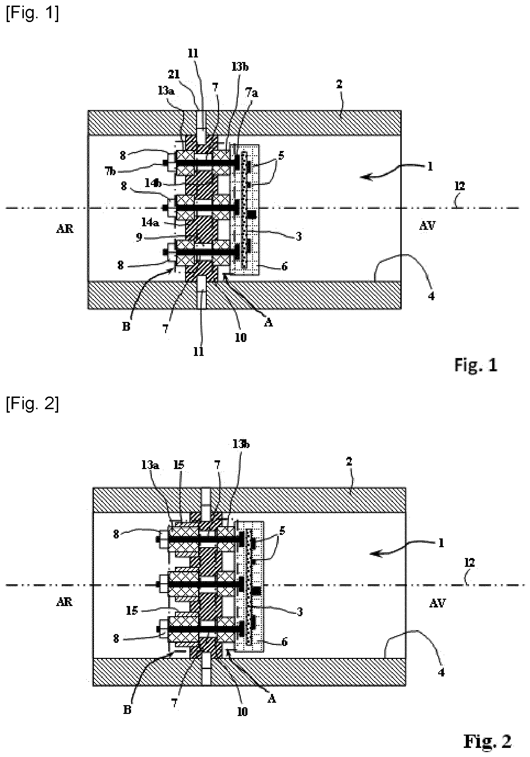

En se reportant à la figure 1, une fusée électronique 1 selon un premier mode de réalisation est destinée à venir équiper un projectile dont seule une partie du corps 2 est représentée. Le corps 2 présente une symétrie de révolution d'axe 12 (par exemple cylindrique).

Cette fusée électronique 1 comprend au moins une carte électronique 3 qui est disposée dans un logement 4 du corps 2 du projectile.

La carte porte un certain nombre de composants électroniques 5 et elle est enrobée par un bloc 6 d'un matériau de protection, éventuellement entouré d'un boîtier métallique.

Le matériau de protection pourra être constitué par une résine synthétique, par exemple une résine de type époxy.

La fonction de ce bloc d'enrobage 6 est de rigidifier la carte 3 pour lui permettre de résister à l'accélération de tir sans subir de déformations par flexion qui seraient susceptibles de rompre les pistes conductrices de la carte électronique.

Un tel enrobage rigide est bien connu de l'Homme du Métier et décrit par exemple par les brevets FR2713396 et FR2666190. Comme le proposent ces brevets, l'enrobage pourra éventuellement comporter plusieurs couches successives pour assurer des performances d'isolations thermiques différenciées au niveau des différents composants électroniques 5.

Conformément à l'invention, la carte électronique 3 est solidaire d'au moins une tige support 7 qui est partiellement enrobée par le bloc de protection 6.

Chaque tige support 7 comporte ici une tête 7a qui est noyée dans le bloc de protection 6 et une partie filetée 7b sur laquelle on peut fixer un écrou 8.

Il est possible de coller la tête 7a à la carte 3 avant enrobage par le bloc de protection 6.

Il est également possible (comme visible sur les figures) de disposer la carte électronique 3 à distance des têtes 7a des tiges, puis de noyer à la fois les têtes 7a des tiges et la carte 3 dans le même bloc 6. Une telle disposition assure un découplage entre les tiges support 7 et la carte 3. La solidarisation de la carte électronique 3 et des tiges 7 est alors assurée uniquement par l'intermédiaire du bloc 6.

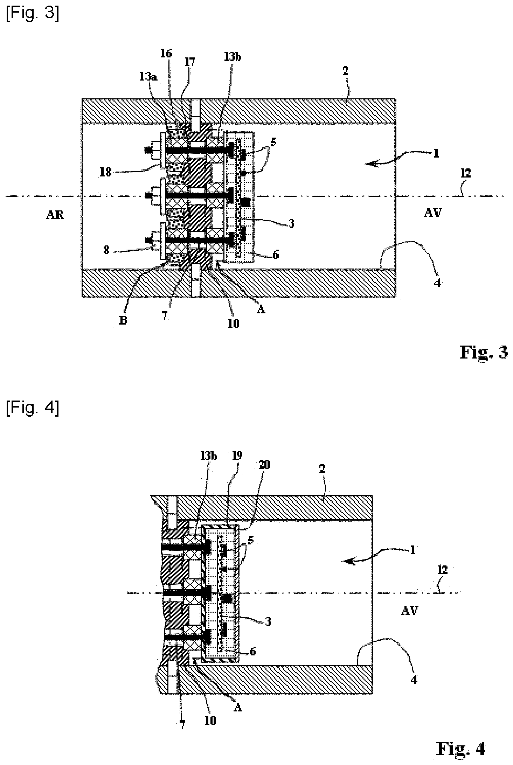

On pourra également, comme représenté à la figure 4, rendre les têtes 7a solidaire d'un boîtier 19 entourant le bloc 6 renfermant la carte 3.

Il y a sur les modes de réalisation décrits trois tiges support 7 pour chaque fusée 1. Un nombre de tiges différent est bien entendu possible. Suivant la taille de la carte 3 on pourra prévoir au moins une tige support (petite carte) ou, pour des cartes électronique plus grandes, 4 à 10 tiges supports, régulièrement réparties angulairement autour de l'axe 12 du projectile.

Chaque tige support 7 est engagée au travers d'un trou 9 d'une paroi 10 qui est solidaire du corps 2 de projectile.

Sur les modes de réalisation décrits, la paroi 10 est rendue solidaire du corps 2 par une ou plusieurs goupilles radiales 11 qui traversent chacune un trou radial 21 du corps 2. Il est bien entendu que tout autre mode de solidarisation est possible : filetage, soudure. La paroi 10 pourrait également être formée d'une seule pièce avec le corps 2.

La tige 7 est rendue solidaire de la paroi 10 par un moyen de fixation qui comprend ici l'écrou 8.

Conformément à l'invention un premier moyen de découplage A est interposé entre le bloc 6 et la paroi 10 et un second moyen de découplage B est interposé entre le moyen de fixation 8 et la paroi 10. Ces deux moyens de découplage sont répartis sur les différentes tiges 7 comme cela va être décrit par la suite. Le moyen de découplage A ou B de chaque tige étant identique à celui de la tige voisine.

Il est clair qu'il serait possible, pour tenir compte de géométries particulières ou de répartitions de masses différentes sur la carte électronique, de modifier les caractéristiques des moyens de découplage A et B d'une tige 7 à l'autre.

Par ailleurs la carte 3 se trouve disposée vers une partie avant AV du projectile tandis que la paroi 10 est disposée vers une partie arrière AR du projectile. La paroi 10 se trouve ainsi en arrière de la carte 3 dans le sens de parcours du projectile.

Il s'ensuit que, lors du tir du projectile, la carte 3 est entraînée par inertie vers la paroi 10, alors qu'au moment de l'impact sur une cible, la carte 3 est entraînée par inertie à distance de la paroi 10, vers l'avant AV.

On voit donc que le premier moyen de découplage A se trouve fortement sollicité lors du tir du projectile et que le second moyen de découplage B est fortement sollicité à l'impact sur une cible.

Ces deux moyens de découplage étant distincts, il devient possible de les dimensionner de façons différentes pour tenir compte des sollicitations qu'ils doivent absorber.

Conformément au premier mode de réalisation représenté à la figure 1, chaque moyen de découplage A et B comprend au moins un moyen déformable élastiquement qui est ici un tube 13a ou 13b d'un matériau élastomère.

Chaque tube 13a ou 13b se loge dans un lamage 14a ou 14b de la paroi 10. Lorsque l'écrou 8 est serré il comprime légèrement les deux tubes 13a et 13b traversés par la tige 7.

La raideur des tubes élastomères 13a et 13b est choisie par l'Homme du Métier en fonction de la masse du bloc 6 renfermant la carte 3 (et éventuellement du boîtier 19) et du niveau de fréquence à amortir lors du tir (moyen A) ou à l'impact (moyen B).

Les tubes 13a et 13b permettent de découpler la carte électronique 3 de la paroi 10 et assurent l'amortissement des vibrations que la paroi 10 pourrait transmettre à la carte 3.

Le serrage de l'écrou 8 donne une précontrainte qui permet de réduire les mouvements de la carte 3 qui seraient provoqués par le tir en dessous d'un seuil d'accélération.

Par ailleurs les tubes élastomères 13a, 13b permettent d'assurer un découplage transversal de la carte 3 évitant ainsi les vibrations, quel que soit le sens de la sollicitation mécanique reçue.

Ce mode de réalisation est plus particulièrement adapté aux projectiles susceptibles d'être soumis à des efforts transversaux importants (par exemple lors du trajet dans le tube de l'arme).

Il serait possible d'interposer une rondelle entre l'écrou 8 et le tube élastomère 13a. Ceci permettrait de mieux répartir les efforts de précontrainte et empêcherait le cisaillement du tube élastomère 13a, 13b lors du serrage.

D'autres moyens déformables élastiquement seraient possibles. On pourra par exemple remplacer l'un et/ou l'autre des tubes élastomères 13a,13b par un ressort de compression, ou bien par un empilement de rondelles ressort. De telles solutions permettent d'accroître la raideur de la liaison entre la carte électronique 3 et la paroi 10 au niveau de l'un ou de l'autre moyen de découplage A ou B. La raideur de la liaison sera adaptée à la masse du bloc 6 et aux fréquences vibratoires dont on veut isoler la carte électronique 3 (hautes fréquences de vibration du corps d'obus).

La figure 2 montre un deuxième mode de réalisation de l'invention qui diffère du précédent par la nature du second moyen de découplage B.

Conformément à ce mode de réalisation, le second moyen de découplage B comprend un dispositif permettant d'absorber de façon contrôlée l'énergie due à un choc, en particulier par déformation irréversible d'un matériau.

Le but recherché est d'amortir l'énergie reçue consécutivement à un impact, par exemple sur une cible. Ainsi la carte électronique 3 ne sera pas détériorée lors d'un tel impact dont le niveau de décélération est très fort (-300000 m/s²) et elle sera pleinement opérationnelle, par exemple pour commander le déclenchement du projectile après traversée d'une paroi ou d'une surprotection.

Suivant le mode de réalisation de la figure 2, le dispositif d'absorption d'énergie comprend un tube d'élastomère 13a mais qui est inséré dans une gaine métallique 15, par exemple en cuivre ou en laiton.

Le moyen de fixation 8 est en appui contre le tube d'élastomère 13a, soit directement soit avec interposition d'une rondelle (non représentée).

Ainsi lors de l'impact sur une cible, le moyen de fixation 8 va écraser le tube d'élastomère 13a qui va s'expanser radialement et provoquer la déformation plastique irréversible de la gaine métallique 15, ce qui consommera une partie de l'énergie du choc.

Il est possible en jouant sur la longueur et l'épaisseur de la gaine 15 de contrôler la consommation d'énergie qui est ainsi assurée. On protège alors efficacement la carte électronique 3 contre les impacts sur une cible.

Par ailleurs le premier moyen de découplage constitué par le tube d'élastomère 13b assure la protection lors du tir et vis-à-vis des vibrations, quelle que soit l'orientation de la sollicitation. La raideur des tubes 13b pourra être différente de celle des tubes 13a en fonction des sollicitations rencontrées et des fréquences à filtrer lors du tir.

La figure 3 montre un troisième mode de réalisation de l'invention qui diffère du précédent par la nature du dispositif constituant le second moyen de découplage B.

Suivant ce mode de réalisation, le tube d'élastomère 13a est inséré dans une couche 16 de mousse d'aluminium ou de polymère.

Cette couche 16 de mousse pourra, comme représenté sur la figure 3, être logée dans un lamage 17 aménagé sur la paroi 10. On pourra la coller à la paroi 10 lors du montage.

Il est également possible de mettre en place une seule couche de mousse 16 qui sera traversée par toutes les tiges support 7. Une telle disposition permet de simplifier le montage. Cette couche 16 unique pourra être collée à la paroi 10.

Comme on le voit sur la figure 3, le moyen de fixation 8 comporte une tête élargie 18 qui pourra être constituée par une rondelle métallique ou bien par une collerette solidaire de l'écrou 8.

La tête élargie 18 est appliquée contre le tube d'élastomère 13a lors du serrage de l'écrou 8. Lors de l'impact du projectile sur une cible, la tête élargie 18 peut écraser le tube 13a puis la couche de mousse 16 par inertie.

L'écrasement (déformation irréversible) de la couche de mousse 16 consomme une partie de l'énergie du choc et permet de protéger la carte électronique 3.

Ce mode de réalisation permet d'amortir des chocs d'un niveau supérieur à celui assuré par le mode précédent. Ce niveau dépend de la rigidité de la mousse qui sera choisie. Par ailleurs une couche de mousse d'aluminium ou de polymère peut s'écraser sans expansion radiale ce qui facilite l'intégration du dispositif dans une munition.

La figure 4 montre de façon partielle une variante de réalisation dans laquelle le bloc de résine 6 enrobant la carte 3 est disposé dans un boîtier 19 qui pourra être fermé par un couvercle 20. Le bloc 6 assurant l'étanchéité et la rigidité, le couvercle 20 est facultatif.

On remarque que les tiges 7 pénètrent dans le boîtier 19 et sont en appui par leur têtes élargies 7a contre le fond du boîtier 19. Ce mode de réalisation facilite l'intégration et le montage. Le boîtier 19 peut être équipé des tiges 7 puis recevoir la carte 3 et le bloc 6, qui est coulé dans le boîtier 19 sans qu'il soit nécessaire de prévoir un moule distinct. Le boîtier 19 sera réalisé par exemple en tôle d'aluminium.

Il est clair que cette variante peut être associée aux différents modes de réalisation des second moyens de découplage B qui ont été décrits précédemment en référence aux figures 1 à 3.

Pour exposer de façon simple l'invention les figures ont montré des fusées ne comportant qu'une seule carte électronique 3. Il est clair qu'il est possible de définir une fusée comportant plusieurs cartes électroniques 3, enrobées ou non dans un même bloc de résine 6.

Dans chaque cas la ou les cartes électroniques enrobées 3 seront liées à une paroi 10 en mettant en œuvre des moyens de fixation comportant des moyens de découplage différents en amont et en aval de la paroi.

## Revendications

1. Fusée électronique (1) pour projectile comprenant au moins une carte électronique (3) disposée dans un logement (4) du corps (2) du projectile, carte qui est enrobée par un bloc (6) de matériau de protection, fusée ***caractérisée en ce que*** la carte (3) est solidaire d'au moins une tige support (7) partiellement enrobée par le bloc de protection (6), tige support qui est engagée au travers d'un trou (9) d'une paroi (10) solidaire du corps (2) de projectile, la tige (7) étant rendue solidaire de la paroi (10) par un moyen de fixation (8), un premier moyen de découplage (A) étant interposé entre le bloc (6) et la paroi (10) et un second moyen de découplage (B) étant interposé entre le moyen de fixation (8) et la paroi (10), la carte (3) se trouvant disposée vers une partie avant (AV) du projectile et la paroi (10) vers une partie arrière (AR) du projectile.

2. Fusée électronique selon la revendication 1, **caractérisée en ce que** le premier et/ou le second moyen de découplage (A,B) comprend au moins un moyen déformable élastiquement (13a,13b).

3. Fusée électronique selon la revendication 2, **caractérisée en ce que** le moyen déformable élastiquement est constitué par un ressort et/ou au moins une rondelle déformable et/ou au moins un tube d'élastomère.

4. Fusée électronique selon une des revendications 1 à 3, **caractérisée en ce que** le second moyen de découplage (B) comprend au moins un dispositif (15,16) d'absorption d'énergie.

5. Fusée électronique selon la revendication 4, **caractérisée en ce que** le dispositif d'absorption d'énergie comprend un tube d'élastomère (13a) inséré dans une gaine métallique (15), le moyen de fixation (8) étant en appui contre le tube d'élastomère (13a) de façon à pouvoir écraser celui-ci par inertie lors d'un choc du projectile sur une cible.

6. Fusée électronique selon la revendication 4, **caractérisée en ce que** le dispositif d'absorption d'énergie comprend un tube d'élastomère (13a) inséré dans une couche (16) de mousse d'aluminium ou de polymère, le moyen de fixation (8) ayant une tête élargie (18) pouvant écraser le tube (13a) et la couche (16) de mousse par inertie lors d'un choc du projectile sur une cible.

7. Fusée électronique selon une des revendications 1 à 6, **caractérisée en ce que** le bloc (6) de matériau de protection est disposé dans un boîtier (19) dont une paroi de fond est traversée par la ou les tiges supports (7).

## Patentansprüche

1. - Elektronischer Zünder (1) für ein Geschoss, der mindestens eine elektronische Karte (3) umfasst, die in einer Aufnahme (4) des Körpers (2) des Geschosses angeordnet ist, wobei die Karte von einem Schutzmaterialblock (6) umgeben ist, wobei der Zünder **dadurch gekennzeichnet ist, dass** die Karte (3) mit mindestens einer Stützstange (7) fest verbunden ist, die von dem Schutzblock (6) teilweise umgeben ist, wobei die Stützstange durch ein Loch (9) in einer Wand (10) eingesetzt ist, die mit dem Geschosskörper (2) fest verbunden ist, wobei die Stange (7) mit der Wand (10) durch ein Befestigungsmittel (8) fest verbunden ist, wobei ein erstes Entkopplungsmittel (A) zwischen dem Block (6) und der Wand (10) angeordnet ist und ein zweites Entkopplungsmittel (B) zwischen dem Befestigungsmittel (8) und der Wand (10) angeordnet ist, wobei sich die Karte (3) zu einem vorderen Teil (AV) des Geschosses und die Wand (10) zu einem hinteren Teil (AR) des Geschosses angeordnet befindet.

2. - Elektronischer Zünder nach Anspruch 1, **dadurch gekennzeichnet, dass** das erste und/oder das zweite Entkopplungsmittel (A, B) mindestens ein elastisch verformbares Mittel (13a, 13b) umfasst.

3. - Elektronischer Zünder nach Anspruch 2, **dadurch gekennzeichnet, dass** das elastisch verformbare Mittel von einer Feder und/oder mindestens einer verformbaren Scheibe und/oder mindestens einem Elastomerschlauch gebildet ist.

4. - Elektronischer Zünder nach einem der Ansprüche 1 bis 3, **dadurch gekennzeichnet, dass** das zweite Entkopplungsmittel (B) mindestens eine Energieabsorptionsvorrichtung (15, 16) umfasst.

5. - Elektronischer Zünder nach Anspruch 4, **dadurch gekennzeichnet, dass** die Energieabsorptionsvorrichtung einen Elastomerschlauch (13a) umfasst, der in eine Metallhülle (15) eingesetzt ist, wobei sich das Befestigungsmittel (8) derart auf dem Elastomerschlauch (13a) abstützt, dass dieser bei einem Aufprall des Geschosses auf einem Ziel durch Trägheit zerdrückt werden kann.

6. - Elektronischer Zünder nach Anspruch 4, **dadurch gekennzeichnet, dass** die Energieabsorptionsvorrichtung einen Elastomerschlauch (13a) umfasst, der in eine Aluminium- oder Polymerschaumschicht (16) eingesetzt ist, wobei das Befestigungsmittel (8) einen erweiterten Kopf (18) hat, der den Schlauch (13a) und die Schaumschicht (16) bei einem Aufprall des Geschosses auf einem Ziel durch Trägheit zerdrücken kann.

7. - Elektronischer Zünder nach einem der Ansprüche 1 bis 6, **dadurch gekennzeichnet, dass** der Schutzmaterialblock (6) in einem Gehäuse (19) angeordnet ist, von dem eine Bodenwand von der oder den Stützstangen (7) durchquert wird.

## Claims

1. - Electronic fuze (1) for a projectile, including at least one electronic board (3) disposed in a housing (4) of the body (2) of the projectile, the board being encapsulated in a block (6) of protective material, wherein the fuze is **characterised in that** the board (3) is secured to at least one support rod (7) partially encapsulated in the protective block (6), the support rod being inserted through a hole (9) in a wall (10) integral with the body (2) of the projectile, the rod (7) being secured to the wall (10) by a fastening means (8), a first decoupling means (A) being interposed between the block (6) and the wall (10) and a second decoupling means (B) being interposed between the fastening means (8) and the wall (10), the circuit (3) being located towards a front part (AV) of the projectile and the wall (10) being located towards a rear part (AR) of the projectile.

2. - The electronic fuze according to claim 1, **characterised in that** the first and/or second decoupling means (A,B) includes at least one elastically deformable means (13a,13b).

3. - The electronic fuze according to claim 2, **characterised in that** the elastically deformable means consists of a spring and/or at least one deformable washer and/or at least one elastomer tube.

4. - The electronic fuze according to any one of claims 1 to 3, **characterised in that** the second decoupling means (B) includes at least one energy absorbing device (15,16).

5. - The electronic fuze according to claim 4, **characterised in that** the energy absorbing device includes an elastomer tube (13a) inserted in a metal sheath (15), the fastening means (8) bearing against the elastomer tube (13a) so as to be able to crush the latter by inertia upon impact of the projectile on a target.

6. - The electronic fuze as claimed in claim 4, **characterised in that** the energy absorbing device includes an elastomer tube (13a) inserted in a layer (16) of aluminum foam or polymer foam, the fastening means (8) having an enlarged head (18) capable of crushing the tube (13a) and the foam layer (16) by inertia upon impact of the projectile on a target.

7. - The electronic fuze according to any one of claims 1 to 6, **characterised in that** the block (6) of protective material is arranged in a casing (19) with the support rod(s) (7) passing through a bottom wall of the casing (19).
